# EUROPÄISCHE PATENTSCHRIFT

(11) **EP 0 809 350 B1**
(45) Veröffentlichungstag und Bekanntmachung des Hinweises auf die Patenterteilung: **20.03.2002**
(21) Anmeldenummer: 97107250.9
(22) Anmeldetag: 02.05.1997
(51) Int. Cl.: H03B 5/36

(54) **Digital einstellbarer Quarzoszillator mit monolithisch integrierter Oszillatorschaltung**
Digitally controlled quartz oscillator and monolithic integrated oscillator circuit
Oscillateur à quartz commandé numériquement et circuit oscillateur intégré monolithique

(30) Priorität: 25.05.1996 DE 19621228
(43) Veröffentlichungstag der Anmeldung: 26.11.1997
(73) Patentinhaber: MICRONAS Semiconductor Holding AG, 8050 Zürich (CH)
(72) Erfinder: Theus, U, Dr., 79194 Gundelfingen (DE); Greitschus, Norbert, 79108 Freiburg (DE)
(74) Vertreter: Hornig, Leonore, Dr.

(56) Entgegenhaltungen:
- EP-A- 0 398 331
- EP-A- 0 641 080
- US-A- 4 814 640
- PATENT ABSTRACTS OF JAPAN vol. 004, no. 059 (E-009), 2.Mai 1980 & JP 55 028632 A (SEIKO INSTR & ELECTRONICS LTD), 29.Februar 1980,
- PATENT ABSTRACTS OF JAPAN vol. 017, no. 518 (E-1434), 17.September 1993 & JP 05 136707 A (KOKUSAI ELECTRIC CO LTD), 1.Juni 1993,
- IEICE TRANSACTIONS ON ELECTRONICS, Bd. E76-C, Nr. 5, 1.Mai 1993, Seiten 701-707, XP000381111 SHIGEO KUBOKI ET AL: "DESIGN CONSIDERATIONS FOR LOW-VOLTAGE CRYSTAL OSCIL-LATOR CIRCUIT IN A 1.8-V SINGLE CHIP MICROPROCESSOR"

## Beschreibung

Die Erfindung betrifft einen digital einstellbaren Quarzoszillator mit einer monolithisch integrierten Oszillatorschaltung, die eine zu dem Schwingquarz parallel geschaltete Serienschaltung mit einer ersten und einer zweiten Frequenzeinstellkapazität C1, C2, von denen zumindest eine digital schaltbar ist, und eine zu dem Schwingquarz parallelgeschaltete Inverterschaltung mit einem parallelgeschalteten Rückkopplungswiderstand Rₖ und einem hinter den Ausgang der Inverterschaltung geschalteten Widerstand R enthält.

Ein derartiger Quarzoszillator, der in einer Parallelresonanzschaltung betrieben wird, ist aus "Entwurf von Quarzoszillatoren", Bernd Neubig, UKW-Berichte 19 (1979), Heft 2 und 3 bekannt. Es handelt sich dabei um einen Pierce-Oszillator. Dieser kann dazu verwendet werden, für eine integrierte Schaltung eine stabile Frequenz zur Verfügung zu stellen, die durch die schaltbare Frequenzeinstellkapazität in einem geringen Bereich veränderbar ist. Hierbei wird die hohe Güte des Quarzes, seine geringe Alterung und Temperaturdrift und die hohe Herstellungsgenauigkeit dazu ausgenutzt, stabile Frequenzen zu erzeugen. Über eine Regelschleife (PLL-phase locked loop) kann durch Schalten der Kapazitäten eine Synchronisierung des Quarzoszillators mit einer vorgegebenen Frequenz durchgeführt werden. Der Rückkopplungswiderstand Rₖ ist hochohmig und dient dazu, den Arbeitspunkt der Inverterschaltung einzustellen. Der Widerstand R hinter dem Ausgang der Inverterschaltung wird so dimensioniert, daß er für eine konstante Amplitude des Oszillators sorgt. Er ist von der Transkonduktanz der Inverterschaltung und der Größe der Frequenzeinstellkapazitäten C1, C2 abhängig.

Nachteilig an dieser Oszillatorschaltung ist, daß Frequenzänderungen nur in geringem Maße möglich sind. Denn mit der Frequenzänderung, d.h. mit der Änderung der Frequenzeinstellkapazitäten C1, C2 ändern sich die Bedingungen für eine stabile Schwingung des Quarzoszillators, insbesondere für stabile Frequenz und stabile Amplitude. Es ändern sich sowohl die Anforderungen an die Transkonduktanz der Inverterschaltung als auch an den hinter ihren Ausgang geschalteten Widerstand R.

Der Erfindung liegt die Aufgabe zugrunde, eine Oszillatorschaltung zu schaffen, mit der eine Frequenzänderung in einem größeren Bereich möglich ist.

Diese Aufgabe wird durch einen gattungsgemäßen Quarzoszillator gelöst, bei dem die Inverterschaltung zueinander parallelgeschaltete Inverterstufen, die erste Kapazität zueinander parallel geschaltete Kapazitätsstufen und die zweite Kapazität C1, C2 jeweils zueinander parallelgeschaltete zweite Kapazitätsstufen umfaßt, und Schaltelemente derart vorgesehen sind, daß jeweils eine Inverterstufe und eine erste und eine zweite Kapazitätsstufe mit einem Steuersignal gleichzeitig an- bzw. abschaltbar sind.

Da bei dem erfindungsgemäßen Oszillator mit dem Hinzunehmen bzw. Wegschalten der Kapazitätsstufen, welche die Frequenzänderung bedingen, gleichzeitig eine Inverterstufe hinzugefügt bzw. weggeschaltet wird, wird mit der Frequenzänderung die Transkonduktanz an die geänderte Frequenz angepaßt. Somit ist eine stabile Schwingung des Quarzoszillators über einen weiteren Frequenzbereich möglich.

Gemäß einer vorteilhaften Weiterbildung der Erfindung enthält eine Inverterstufe jeweils zwei in Reihe geschalte, jeweils mit einem festen Potential verbundene Verstärkertransistoren von entgegengesetztem Leitfähigkeitstyp, mit denen jeweils ein als Schaltelement wirkender Schalttransistor des gleichen Leitfähigkeitstyps in Reihe geschaltet ist. Die erste Kapazitätsstufe ist jeweils über ein Schaltelement mit den Gate-Elektroden der Verstärkertransistoren verbunden. Die zweite Kapazitätsstufe ist jeweils über ein zweites Schaltelement mit dem Widerstand R verbunden. Der Widerstand R ist dabei abhängig von der Größe der Transkonduktanz der Inverterstufe so gewählt, daß eine konstante Amplitude der Oszillatorschwingung erreicht wird. Die Transkonduktanz der Inverterstufe wird durch die Dimensionierung der Verstärkertransistoren bestimmt. Es ist vorteilhaft, die Verstärkertransistoren und die Schalttransistoren als CMOS-Transistoren auszubilden.

Gemäß einer vorteilhaften Weiterbildung der Erfindung ist in den Inverterstufen jeweils in Reihe mit dem Verstärkertransistor und dem Schalttransistor eines Leitfähigkeitstyps ein weiterer Testschalttransistor des gleichen Leitfähigkeitstyps geschaltet, und eine Testsignalquelle ist derart angeordnet, daß mit einem von dieser gelieferten Testsignal die Schalttransistoren in den leitenden oder nichtleitenden Zustand schaltbar sind, und gleichzeitig der Rückkopplungswiderstand R_{K} über Testschaltmittel zu- oder abschaltbar ist. Hierdurch wird erreicht, daß der Quarzoszillator mit dem Testsignal wahlweise in einen Normalzustand, in dem der Quarzoszillator schwingt, und in einen Testzustand geschaltet werden kann. Für den Normalzustand werden die Testschalttransistoren von dem Testsignal in den leitenden Zustand geschaltet, und der Rückkopplungswiderstand wird hinzugeschaltet, so daß der Quarzoszillator auf seiner Resonanzfrequenz schwingt. Für den Testzustand werden die Schalttransistoren mit dem Testsignal in den nichtleitenden Zustand geschaltet, und der Rückkopplungswiderstand wird abgeschaltet. Hierdurch wird die jeweilige Inverterstufe stromlos, und die Rückkopplung wird unterbrochen. In diesem Zustand können die Kapazitäten der verschiedenen Inverterstufen über die dazugehörigen Schaltelemente eingeschaltet werden. In dem Testzustand ist es möglich, die Leckströme der Kapazitäten der Inverterstufen zu messen. Dies ist nur im Testzustand möglich, da die Kapazitäten im Normalzustand jeweils über den Widerstand R an den Ausgang der Kaskodenstufen der jeweiligen Inverterstufe angeschlossen sind. Zudem erfolgt diese Verbindung über den Rückkopplungszweig mit dem Kopplungswiderstand R_{K}, so daß der Strom in der gesamten Oszillatorschaltung fließen würde. Dadurch, daß getestet werden kann, ob die Kondensatoren Leckströme aufweisen oder nicht, wird es möglich, in dem Testzustand festzustellen, ob der Quarzoszillator den von Anwender und Hersteller vorgegebenen Anforderungen genügt. Für viele Anwendungen ist eine Leckstromfreiheit auf Dauer erforderlich. Somit können aufgrund der Untersuchungen im Testzustand die den Anforderungen genügenden bzw. nicht genügenden Oszillatorschaltungen bestimmt und aussortiert werden. Die Leckströme können insbesondere durch schlechte Oxideigenschaften des Oxids zwischen den Kondensatorplatten zustande kommen. Die Leckstromfreiheit kann bei einer bestimmten Spannung und bei einer bestimmten Temperatur überprüft werden, woraus auf eine Leckstromfreiheit für eine lange Zeit unter Normalbedingungen geschlossen werden kann.

Günstigerweise kann der Rückkopplungswiderstand R_{K} komplementäre, als Testschaltmittel wirkende Transistoren umfassen, deren Gate-Elektroden mit der Testsignalquelle verbunden sind. Dadurch ist der Rückkopplungswiderstand durch Schalten der Transistoren mit dem von der Testsignalquelle gelieferten Testsignal einfach an- und abschaltbar.

Ferner ist es vorteilhaft, wenn die Testschalttransistoren jeweils zwischen den Verstärkertransistor und den Schalttransistor geschaltet sind. Dann bilden die Schalttransistoren am Ausgang der jeweiligen Inverterstufe in ihrem ausgeschalteten Zustand einen hochohmigen Widerstand, so daß die Gatekapazität der Testschalttransistoren nicht in die parallelgeschaltete Frequenzeinstellkapazität C1, C2 eingeht. Die Gatekapazität wird im leitenden Zustand durch die Kapazität zwischen der Gate-Elektrode und dem vorhandenen Kanal zwischen Drain- und Source-Zone gebildet. Da die Testschalttransistoren im Normalzutsand des Quarzoszillators immer leitend sind, weisen sie im Normalzustand auch immer eine Gatekapazität auf.

Auch ist es günstig, wenn der Widerstand R Teilwiderstände umfaßt, von denen jeweils einer hinter den Ausgang einer oder mehrerer Inverterstufen geschaltet ist. Da der Widerstand R für eine konstante Amplitude der Schwingung sorgt, muß dieser bei einer starken Frequenzänderung, welche durch Hinzuschalten verschiedener Kapazitäten entsteht, entsprechend angepaßt werden. Abhängig davon, wie stark die Kapazität durch Hinzuschalten von einzelnen Stufen geändert wird, kann hinter dem Ausgang einer jeden Inverterstufe oder hinter dem Ausgang einer Gruppe von Inverterstufen ein Teilwiderstand R₁ geschaltet werden.

Gemäß einem weiteren Ausführungsbeispiel der Erfindung ist die Anzahl der ersten und die Anzahl der zweiten Kapazitätsstufen jeweils größer, als die Anzahl der Inverterstufen, und es sind Schaltelemente derart vorgesehen, daß eine erste und eine zweite Kapazitätsstufe mit einem Steuersignal an- bzw. abschaltbar sind. Somit kann eine geeignete Anzahl von Kapazitätsstufen auch ohne Inverterstufen an- bzw. abgeschaltet werden. Dies ist für die Frequenzbereiche sinnvoll, in denen die Stabilität der Oszillatorschwingung durch eine Kapazitätsänderung nicht ungewünscht beeinträchtigt wird. Es können abwechselnd Kapazitätsstufen mit und ohne Inverterstufe an- bzw. abgeschaltet werden.

Im folgenden wird die Erfindung anhand der Zeichnung näher erläutert.

Es zeigen:
Fig. 1 ein erstes Ausführungsbeispiel des erfindungsgemäßen Quarzoszillators,
Fig. 2 ein zweites Ausführungsbeispiel des erfindungsgemäßen Quarzoszillators,
Fig. 3 ein drittes Ausführungsbeispiel des erfindungsgemäßen Quarzoszillators und
Fig. 4 ein Blockschaltbild, das eine den erfindungsgemäßen Quarzoszillator enthaltende Regelschleife darstellt.

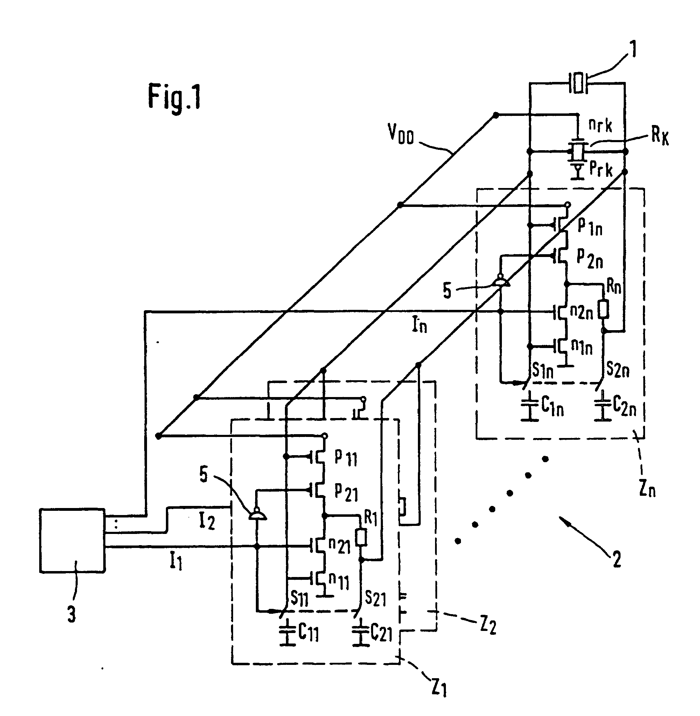

Die Fig. 1 zeigt einen Quarzoszillator mit einem Schwingquarz 1 und einer Oszillatorschaltung 2. Die Oszillatorschaltung 2 ist auf einem Halbleiterchip in CMOS-Technologie integriert. Der Schwingquarz 1 befindet sich außerhalb des Halbleiterchips. Parallelgeschaltet zu dem Schwingquarz 1 sind n Grundzellen Z₁ ... Zₙ, zu denen wiederum ein Rückkopplungswiderstand R_{K} parallelgeschaltet ist.

Jede der Grundzellen Zᵢ umfaßt zwei Kapazitäten C₁ᵢ, C₂ᵢ, welche zu dem Quarz 1 parallelgeschaltet sind, wobei jeweils ein Anschluß an das Massepotential angeschlossen ist. Zudem enthält jede Grundzelle Zᵢ eine zu dem Quarz 1 parallelgeschaltete Inverterstufe, zwei in Reihe geschaltete, mit einem festen Potential, der Betriebsspannung V_{DD} bzw. Masse, verbundene Verstärkertransistoren p₁ᵢ, n₁ᵢ. Mit diesen ist jeweils ein Schalttransistor p₂ᵢ, n₂ᵢ des gleichen Leitfähigkeitstyps in Reihe geschaltet. Am Ausgang der Inverterstufe ist ein Widerstand Rᵢ angeschlossen. Die erste Kapazität C₁ᵢ ist über einen Schalter S₁ᵢ an die miteinander verbundenen Gate-Elektroden der Verstärkertransistoren p₁ᵢ und n₁ᵢ angeschlossen. Die zweite Kapazität C₂ᵢ ist über einen zweiten Schalter S₂ᵢ mit dem Widerstand Rᵢ verbunden. Eine Steuersignalqüelle 3 liefert Steuersignale I₁ ... Iₙ. Mit dem Steuersignal Iᵢ werden jeweils die Schalter S₁ᵢ, S₂ᵢ der jeweiligen Grundzelle Zᵢ eingeschaltet. Gleichzeitig wird mit dem Steuersignal Iᵢ der Transistor n₂ᵢ und mit dem dazu inversen Signal IQᵢ der Transistor p₂ᵢ eingeschaltet. Dabei wird das Steuersignal Iᵢ durch einen Inverter 5 zu dem Signal IQᵢ invertiert.

Durch die Anzahl der geschlossenen Schalter S₁ᵢ, S₂ᵢ in den Grundzellen Zᵢ wird die wirksame Lastkapazität des Schwingquarzes 1 und damit die Resonanzfrequenz des Quarzoszillators bestimmt. Damit ein stabiles Schwingen bei einer bestimmten Resonanzfrequenz erreicht wird, muß die Transkonduktanz an die jeweilige Resonanzfrequenz angepaßt werden. Dies erfolgt dadurch, daß mit Hinzuschalten der Kapazitäten C₁ᵢ, C₂ᵢ gleichzeitig die Schalttransistoren p₂ᵢ, n₂ᵢ mit dem gemeinsamen Steuersignal Iᵢ bzw. IQᵢ eingeschaltet werden. Somit wird die jeweilige Inverterstufe und der dieser nachgeschaltete Widerstand Rᵢ gleichzeitig mit den Kapazitäten hinzugeschaltet. Die Inverterstufe sorgt für eine geeignete Verstärkung bei der geänderten Resonanzfrequenz, der Widerstand Rᵢ sorgt für eine konstante Amplitude der Schwingung. Die Größe des Widerstandes Rᵢ wird abhängig von der Größe der Verstärkung der Inverterstufe und somit abhängig von den Kapazitätsstufen und der Dimensionierung der Verstärkertransistoren n₁ᵢ, p₁ᵢ gewählt.

Der Rückkopplungswiderstand R_{K} enthält zwei komplementäre Rückkopplungstransistoren p_{rK} und n_{rK}. Der Rückkopplungswiderstand R_{K} stellt den Arbeitspunkt der Grundzellen Vᵢ ein. Die Schalter S₁ᵢ, S₂ᵢ können aus komplementären Transistoren bestehen, denen das Steuersignal Iᵢ und das inverse Steuersignal IQᵢ zugeführt wird.

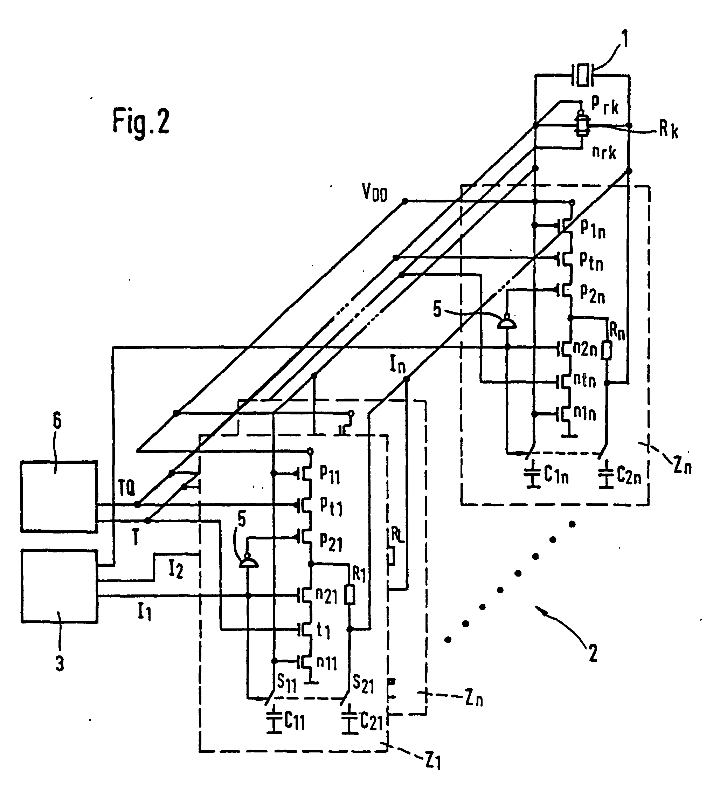

Fig. 2 zeigt ein zweites Ausführungsbeispiel des erfindungsgemäßen Quarzoszillators. Gleiche Bezugszeichen, wie die in Fig. 1 verwendeten, beziehen sich auf die gleichen Teile des Quarzoszillators. Es werden daher im folgenden nur die Änderungen beschrieben. Die Inverterstufen der Grundzellen Zᵢ enthalten zwei weitere Testtransistoren von entgegengesetztem Leitungstyp pₜᵢ, nₜᵢ. Diese sind jeweils zwischen den Verstärkertransistor p₁ᵢ, n₁ᵢ und den Schalttransistor p₂ᵢ , n₂ᵢ vom gleichen Leitfähigkeitstyp in Reihe geschaltet. Die Gate-Elektroden der Testtransistoren pₜᵢ, nₜᵢ werden mit einem Signal T bzw. TQ, das von einer Testsignalquelle 6 geliefert wird, angesteuert. Die Testsignalquelle 6 ist ebenfalls mit dem Rückkopplungswiderstand R_{K} verbunden. Die Testsignale T, TQ steuern die Gate-Elektroden der Rückkopplungstransistoren pᵣₖ und nᵣₖ des Rückkopplungswiderstands R_{K}. Im Normalzustand liefert die Testsignalquelle 6 die Testsignale T und TQ so, daß die Testtransistoren pₜᵢ, nₜᵢ und die Rückkopplungstransistoren pᵣₖ, nᵣₖ leitend sind. Die Funktion des Oszillators in dem Normalzustand entspricht der Funktion des Oszillators aus Fig. 1. Im Testzustand liefert die Testsignalquelle 6 die Testsignale T und TQ so, daß die Testtransistoren pₜᵢ, nₙᵢ und die Rückkopplungstransistoren pᵣₖ, nᵣₖ nicht leitend sind. In diesem Fall sind die jeweiligen Inverterstufen stromlos und die Rückkopplung ist unterbrochen. Wenn die Kapazitäten C₁ᵢ und C₂ᵢ über die Schalter S₁ᵢ, S₂ᵢ eingeschaltet werden, können die Leckströme der Kapazitäten C₁ᵢ, C₂ᵢ ohne Einfluß der übrigen Schaltungselemente gemessen werden. Alternativ kann dieser Testzustand auch dadurch realisiert werden, daß die Leitungen mit dem Steuersignal Iᵢ über eine Logikschaltung, z. B. einer OR-Schaltung, mit dem Testsignal T verbunden werden.

Die Widerstände Rᵢ dieses Ausführungsbeispiels sind so dimensioniert, daß die Widerstände der Testtransistoren nₜᵢ, pₜᵢ in ihrem An-Zustand mitberücksichtigt sind. Die Widerstände Rᵢ sind in Fig. 2 daher niederohmiger als in der Figur 1.

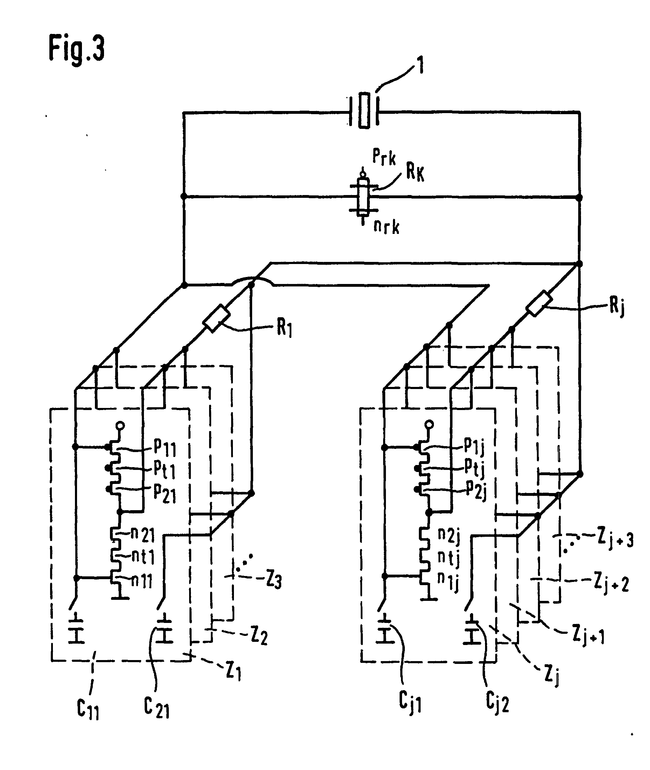

Fig. 3 zeigt einen Ausschnitt aus einem dritten Ausführungsbeispiel des erfindungsgemäßen Quarzoszillators. Die Elemente mit dem gleichen Bezugszeichen wie in Fig. 2 entsprechen den gleichen Elementen. Zur Vereinfachung und Übersichtlichkeit sind Steuersignalquelle, Betriebsspannungsquelle, Testsignalquelle und die entsprechenden Zuleitungen nicht dargestellt. Sie werden analog wie in Fig. 2 realisiert. In Fig. 3 sind mehrere Grundzellen Z₁, Z₂ ... Zᵢ zu einer Gruppe zusammengefaßt, bei denen ein Widerstand R₁ hinter den gemeinsamen Ausgang der Inverterstufen der Gruppe der Grundzellen geschaltet ist. Die Grundzellen Zⱼ ... Z_{j + n} bilden eine zweite Gruppe von Grundzellen, hinter deren Ausgang ein Widerstand Rⱼ geschaltet ist. Bei diesem Ausführungsbeispiel werden Aufwand und Fläche des IC's reduziert, da für eine bestimmte Anzahl von Grundzellen ein gemeinsamer Widerstand Rᵢ, Rⱼ verwendet wird.

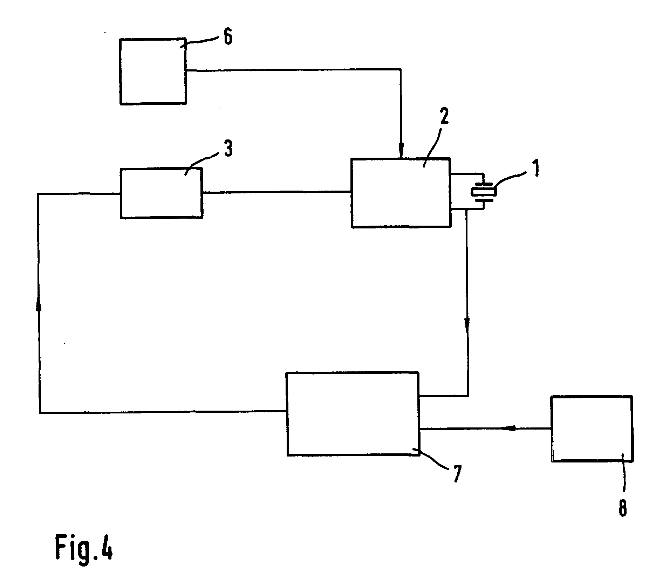

Fig. 4 zeigt ein Blockschaltbild in dem der erfindungsgemäße Quarzoszillator in einer Regelschleife betrieben wird. Der Schwingquarz 1 befindet sich außerhalb des IC's, alle anderen Elemente sind auf dem IC integriert. Das Ausgangssignal der Oszillatorschaltung 2 wird einer Vergleichseinrichtung 7 zum Frequenzvergleich mit einem Referenzsignal aus einer Referenzfrequenzquelle 8 zugeführt. Das Ausgangssignal der Vergleichseinrichtung 7 ist abhängig von dem Unterschied der Frequenzen des Ausgangssignals der Oszillatorschaltung und der Referenzfrequenzquelle 8. Abhängig von dem Ausgangssignal der Vergleichseinrichtung 7 wird in der Steuersignalquelle ein digitales Signal erzeugt, das der Oszillatorschaltung 2 zugeführt wird. Dieses Signal bestimmt, welche der Kapazitäten C₁ᵢ, C₂ᵢ zu- oder abgeschaltet werden. Dadurch wird entsprechend die Frequenz der Oszillatorschaltung 2 geändert. Diese Regelung erfolgt so lange, bis die Vergleichseinrichtung 7 Frequenzübereinstimmung von dem Ausgangssignal der Oszillatorschaltung 2 und dem Ausgangssignal der Referenzfrequenzquelle 8 mißt. Ist dieser Wert erreicht, wird die Frequenz der Oszillatorschaltung festgehalten. Die Testsignalquelle 6 ist in diesem Fall in den Normalzustand geschaltet. Sie wird lediglich zum Testen der Leckstromfreiheit der Kapazitäten in den Testzustand umgeschaltet.

## Patentansprüche

1. Digital einstellbarer Quarzoszillator mit einer monolithisch integrierten Oszillatorschaltung (2), die eine zu dem Schwingquarz parallel geschaltete Serienschaltung mit einer ersten und einer zweiten Frequenzeinstellkapazität C1, C2, von denen zumindest eine digital schaltbar ist und deren Verbindungspunkt an ein Massepotential angeschlossen ist und eine zu dem Schwingquarz (1) parallel geschaltete Inverterschaltung mit einem parallel geschalteten Rückkopplungswiderstand (Rₖ) und einem hinter den Ausgang der Inverterschaltung geschalteten Widerstand R enthält, **dadurch gekennzeichnet, daß** die Inverterschaltung zueinander parallel geschaltete Inverterstufen, die erste Kapazität zueinander parallel geschaltete Kapazitätsstufen (C₁ᵢ) und die zweite Kapazität C2 zueinander parallel geschaltete zweite Kapazitätsstufen (C₂ᵢ) umfaßt, und Schaltelemente (S₁ᵢ, S₂ᵢ, p₂ᵢ, n₂ᵢ) derart vorgesehen sind, daß jeweils eine Inverterstufe und eine erste und zweite Kapazitätsstufe (C₁ᵢ, C₂ᵢ) mit einem Steuersignal (Iᵢ) gleichzeitig an- bzw. abschaltbar sind.

2. Quarzoszillator nach Anspruch 1, **dadurch gekennzeichnet, daß** eine Inverterstufe jeweils zwei in Reihe geschaltete, jeweils mit einem festen Potential verbundene Verstärkertransistoren (p₁ᵢ, n₁ᵢ) von entgegengesetztem Leitfähigkeitstyp enthält, mit denen jeweils ein als Schaltelement wirkender Schalttransistor (p₂ᵢ, n₂ᵢ) des gleichen Leitfähigkeitstyps in Reihe geschaltet ist.

3. Quarzoszillator nach Anspruch 2, **dadurch gekennzeichnet, daß** in den Inverterstufen jeweils in Reihe mit dem Verstärkertransistor (p₁ᵢ, n₁ᵢ) und dem Schalttransistor (p₂ᵢ, n₂ᵢ) eines Leitfähigkeitstyps ein weiterer Testschalttransistor (pₜᵢ, nₜᵢ) des gleichen Leitfähigkeitstyps geschaltet ist, und eine Testsignalquelle derart angeordnet ist, daß mit einem von dieser gelieferten Testsignal die Schalttransistoren (p₂ᵢ, n₂ᵢ) in den leitenden oder nichtleitenden Zustand schaltbar sind, und gleichzeitig der Rückkopplungswiderstand R_{K} über Testschaltmittel zu-oder abschaltbar ist.

4. Quarzoszillator nach Anspruch 3, **dadurch gekennzeichnet, daß** der Rückkopplungswiderstand R_{K} ein Paar komplementärer, als Testschaltmittel wirkender Transistoren (p_{rK}, n_{rK}) umfaßt, deren Gateelektroden mit der Testsignalquelle (6) verbunden sind.

5. Quarzoszillator nach Anspruch 3 oder 4, **dadurch gekennzeichnet, daß** die Testschalttransistoren (pₜᵢ, nₜᵢ) jeweils zwischen den Verstärkertransistor (p₁ᵢ, n₁ᵢ) und den Schalttransistor (p₂ᵢ, n₂ᵢ) geschaltet sind.

6. Quarzoszillator nach einem der vorangehenden Ansprüche, **dadurch gekennzeichnet, daß** der Widerstand R Teilwiderstände (Rᵢ) umfaßt, von denen jeweils einer hinter den Ausgang einer oder mehrerer Inverterstufen geschaltet ist.

7. Quarzoszillator nach einem der vorangehenden Ansprüche, **dadurch gekennzeichnet, daß** die Anzahl der ersten und die Anzahl der zweiten Kapazitätsstufen (C₁ᵢ, C₂ᵢ) jeweils größer ist als die Anzahl der Inverterstufen, und daß Schaltelemente (S_{1K}, S_{2K}) derart vorgesehen sind, daß eine erste und eine zweite Kapazitätsstufe (C1_{K}, C_{2K}) mit einem Steuersignal (I_{K}) an- bzw. abschaltbar sind.

## Claims

1. A digitally adjustable crystal oscillator with a monolithic integrated oscillator circuit (2) comprising a series combination of a first frequency-adjusting capacitor C1 and a second frequency-adjusting capacitor C2 connected in parallel with the quartz crystal (1), at least one of the frequency-adjusting capacitors being digitally switchable and the junction point of the frequency-adjusting capacitors being connected to ground potential, and an inverter circuit connected in parallel with the quartz crystal (1) and having a feedback resistor (R_{K}) connected in parallel therewith and a resistor R connected behind its output, **characterized in that** the inverter circuit comprises parallel-connected inverter stages, that the first capacitor C1 comprises parallel-connected first capacitance stages (C₁ᵢ), that the second capacitor C2 comprises parallel-connected second capacitance stages (C₂ᵢ), and that switching elements (S₁ᵢ, S₂ᵢ, p₂ᵢ, n₂ᵢ) are provided such that a respective one of the inverter stages and a first and a second capacitance stage (C₁ᵢ, C₂ᵢ) are switchable into or out of circuit simultaneously by means of a control signal (Iᵢ).

2. A crystal oscillator as claimed in claim 1, **characterized in that** each of the inverter stages contains two series-connected amplifying transistors (p₁ᵢ, nᵢ₁) of opposite conductivity types which are connected to respective fixed potentials and each have a respective switching transistor (p₂ᵢ, n₂ᵢ) of the same conductivity type connected in series therewith which acts as one of the switching elements.

3. A crystal oscillator as claimed in claim 2, **characterized in that** in each of the inverter stages, a test switching transistor (pₜᵢ, nₜᵢ) is connected in series with the amplifying transistor (p₁ᵢ, n₁ᵢ) and the switching transistor (p₂ᵢ, n₂ᵢ) of one conducitivity type, said test switching transistor (pₜᵢ, nₜᵢ) being of the same conductivity type as the associated switching transistor, and that a test signal source is arranged in such a way that by means of a test signal provided by said test signal source, the switching transistors (p₂ᵢ, n₂ᵢ) are switchable into the conducting or nonconducting state and the feedback resistor R_{K} is simultaneously switchable into or out of circuit via test switching means.

4. A crystal oscillator as claimed in claim 3, **characterized in that** the feedback resistor R_{K} comprises a pair of complementary transistors (p_{rK}, n_{rK}) acting as the test switching means and having their gate electrodes connected to the test signal source (6).

5. A crystal oscillator as claimed in claim 3 or 4, **characterized in that** the respective test switching transistor (pₜᵢ, nₜᵢ) is connected between the associated amplifying transistor (p₁ᵢ, n₁ᵢ) and the associated switching transistor (p₂ᵢ, n₂ᵢ).

6. A crystal oscillator as claimed in any one of the preceding claims, **characterized in that** the resistor R comprises partial resistors (Rᵢ) each of which is connected to the output of one or more inverter stages.

7. A crystal oscillator as claimed in any one of the preceding claims, **characterized in that** the respective number of first capacitance stages (C₁ᵢ) and the respective number of second capacitance stages (C₂ᵢ) are greater than the number of inverter stages, and that switching elements (S_{1K}, S_{2K}) are provided such that a first capacitance stage (C_{1K}) and a second capacitance stage (C_{2K}) are switchable into or out of circuit with a control signal (I_{K}).

## Revendications

1. Oscillateur à quartz réglable de manière numérique comportant un circuit oscillateur (2) qui est intégré de manière monolithique et qui comprend un circuit série qui est branché en parallèle sur le cristal d'oscillation (1) et qui comporte un premier et un deuxième condensateurs de réglage de la fréquence C1 et C2, dont au moins l'un des deux est commutable de manière numérique et dont la borne commune est connectée à un potentiel de masse, et un circuit inverseur qui est branché en parallèle sur le cristal d'oscillation (1) et qui comporte une résistance de rétroaction (R_{K}) branchée en parallèle et une résistance R branchée en arrière de la sortie du circuit inverseur, **caractérisé en ce que** le circuit inverseur comprend des étages inverseurs branchés en parallèle les uns par rapport aux autres, **en ce que** le premier condensateur C1 comprend des premiers étages de condensateur (C₁ᵢ) branchés en parallèle les uns par rapport aux autres, **en ce que** le deuxième condensateur C2 comprend des deuxièmes étages de condensateur (C₂ᵢ) branchés en parallèle les uns par rapport aux autres et **en ce que** l'on prévoit des éléments de commutation (S₁ᵢ, S₂ᵢ, p₂ᵢ, n₂ᵢ) disposés de telle manière que, à chaque fois, un circuit inverseur et un premier et un deuxième étage de condensateur (C₁ᵢ, C₂ᵢ) peuvent être mis en circuit ou mis hors circuit en même temps.

2. Oscillateur à quartz selon la revendication 1, **caractérisé en ce qu'**un circuit inverseur comprend, à chaque fois, deux transistors d'amplification (p₁ᵢ, n₁ᵢ) de types de conduction opposés qui sont branchés en série, qui sont reliés, à chaque fois, à un potentiel fixe et au moyen desquels, à chaque fois, un transistor de commutation (p₂ᵢ, n₂ᵢ) du même type de conduction, qui agit en tant qu'élément de commutation, est branché en série.

3. Oscillateur à quartz selon la revendication 2, **caractérisé en ce que**, dans les étages inverseurs, à chaque fois, en série avec le transistor d'amplification (p₁ᵢ, n₁ᵢ) et le transistor de commutation (p₂ᵢ, n₂ᵢ) d'un type de conduction, on branche un autre transistor de commutation de test (pₜᵢ, nₜᵢ) du même type de conduction et **en ce que** l'on dispose une source de signaux de test (6) disposée de telle manière que, au moyen d'un signal de test délivré par cette dernière, les transistors de commutation (p₂ᵢ, n₂ᵢ) peuvent être commutés à l'état de conduction ou à l'état de non conduction et que, en même temps, la résistance de rétroaction (R_{K}) peut être mise en circuit ou mise hors circuit au moyen de moyens de commutation de test.

4. Oscillateur à quartz selon la revendication 3, **caractérisé en ce que** la résistance de rétroaction (R_{K}) comprend une paire de transistors complémentaires (pᵣₖ, nᵣₖ) qui agissent en tant que moyens de commutation de test et dont les électrodes de porte sont reliées à la source de signaux de test (6).

5. Oscillateur à quartz selon la revendication 3 ou 4, **caractérisé en ce que** les transistors de commutation de test (pₜᵢ, nₜᵢ) sont branchés, à chaque fois, entre le transistor d'amplification (p₁ᵢ, n₁ᵢ) et le transistor de commutation (p₂ᵢ, n₂ᵢ).

6. Oscillateur à quartz selon l'une quelconque des revendications précédentes, **caractérisé en ce que** la résistance R comprend des résistances partielles (R₁) parmi lesquelles, à chaque fois, l'une d'entre elles est branchée derrière la sortie d'un ou de plusieurs étages inverseurs.

7. Oscillateur à quartz selon l'une quelconque des revendications précédentes, **caractérisé en ce que** le nombre des premiers et le nombre des deuxièmes étages de condensateur (C₁ᵢ, C₂ᵢ) est, à chaque fois, plus grand que le nombre des étages inverseurs et **en ce que** l'on prévoit des éléments de commutation disposés de telle manière qu'un premier et un deuxième étages de condensateur (C₁ᵢ, C₂ᵢ) peuvent être mis en circuit ou mis hors circuit par un signal de commande (Iₖ).
